# EUROPÄISCHE PATENTSCHRIFT

(11) **EP 1 136 936 B1**
(45) Veröffentlichungstag und Bekanntmachung des Hinweises auf die Patenterteilung: **27.10.2004**
(21) Anmeldenummer: 00106473.2
(22) Anmeldetag: 24.03.2000
(51) Int. Cl.: G06K 9/00

(54) **Gehäuse für biometrische Sensorchips**
Package for biometrical sensor chips
Boîtier pour capteurs biométriques en puce

(43) Veröffentlichungstag der Anmeldung: 26.09.2001
(73) Patentinhaber: Infineon Technologies AG, 81669 München (DE)
(72) Erfinder: Fries, Manfred, 94336 Hunderdorf (DE); Fischbach, Reinhard, D-81539 München (DE)
(74) Vertreter: Schweiger, Martin, Dipl.-Ing.

(56) Entgegenhaltungen:
- EP-A- 0 057 253
- EP-A- 0 789 334
- WO-A-99/60513
- DE-A- 19 831 570
- US-A- 6 028 773

## Beschreibung

Die Erfindung betrifft Gehäuse für biometrische Sensorchips.

Biometrische Sensorchips werden zunehmend für die Identitätserkennung eingesetzt, sei es für Geldautomaten, für Wertpapier und/oder Kapitaltransfer über elektronische Medien oder zur Erkennung von Zugriffsberechtigungen auf Konten und Datenbanken oder auch andere von Zugriffsberechtigungen abhängige Datensätze. Dazu muß das Gehäuse für biometrische Sensorchips im Gegensatz zu Gehäusen für mikroelektronische Standardhalbleiterchips einen Bereich aufweisen, in dem eine Fingerabdruckprüffläche des biometrischen Sensorchips frei zugänglich ist. Andererseits muß vermieden werden, daß durch elektrostatische Aufladung beispielsweise einer Fingerspitze der Sensorchip bei Berührung der Fingerabdruckprüffläche durch Funkenentladung zerstört wird. Eine entsprechende Anordnung ist z.B. aus der WO 99/60513 bekannt. Weiterhin ergibt sich die Aufgabe, aufgrund der steigenden Nachfrage nach derartigen Gehäusen mit biometrischen Sensorchips eine automatische Massenproduktion in kostengünstiger Weise bereitzustellen.

Aufgabe der Erfindung ist es, für Geräte und Systeme, bei denen der Zugang durch eine Pinnummer geregelt ist, wie z.B. Bankautomaten, Handys und Computer, ein Gehäuse für biometrische Sensorchips anzugeben, bei dem die aktive Struktur des Sensorchips am Gerät oder System nach außen zeigt, so daß der Bediener seinen Finger direkt auf das Sensorchip legen kann. Darüber hinaus ist es Aufgabe der Erfindung, ein rationelles Fertigungsverfahren zur Montage derartiger Gehäuse für biometrische Sensorchips anzugeben.

Diese Aufgabe wird mit dem Gegenstand der unabhängigen Ansprüche gelöst. Bevorzugte Weiterbildungen der Erfindung ergeben sich aus den Unteransprüchen.

Ein erfindungsgemäßes Gehäuse für biometrische Sensorchips mit frei zugänglicher Fingerabdruckprüffläche auf dem Sensorchip, einem Trägersubstrat und einer Außenkontaktfläche auf dem Trägersubstrat hat den Vorteil, daß es in hoher Stückzahl mit einfacher Technologie auf einem Trägersubstrat, das ein Trägerband mit perforierten Rändern bildet, hergestellt werden kann. Auf dem Trägerband können die Außenkontakte teilweise außerhalb eines Gehäuserahmens angeordnet sein, und das Sensorchip kann innerhalb des Gehäuserahmens positioniert sein. Zum Schutz des Sensorchips ist dieser Gehäuserahmen mit einer Massekontaktfläche des Sensorchips elektrisch verbunden zu einem Masserahmen, der wie ein Blitzableiter elektrostatische Aufladungen einer Fingerspitze von der empfindlichen Fingerabdruckprüffläche ablenkt, so daß sich die elektrostatische Aufladung, ohne das Sensorchip zu gefährden, über den Masserahmen entladen kann.

Dazu ist vorzugsweise der Gehäuserahmen aus einem elektrisch leitenden Material hergestellt oder mindestens mit einem elektrisch leitenden Material beschichtet. Die elektrisch leitenden Durchführungen der Außenkontakte in den von dem Gehäuserahmen umschlossenen Innenraum sind elektrisch von dem Gehäuserahmen isoliert, so daß kein Kurzschluß zwischen den Außenkontakten über den Gehäuserahmen auftreten kann. Die Außenkontakte können auf der Oberseite des Trägersubstrats, die auch den Sensorchip trägt, oder auf der gegenüberliegenden Unterseite des Trägersubstrats angeordnet sein.
Sind die Außenkontakte vorzugsweise auf der Unterseite des Trägersubstrats angeordnet, so werden sie durch Bondöffnungen in dem Trägersubstrat und Bonddrähte mit den Kontaktflächen des auf der Oberseite des Trägersubstrats angeordneten Sensorchips verbunden.

Sind die Außenkontakte vorzugsweise auf der Oberseite des Trägersubstrats angeordnet, auf der auch das Sensorchip vorgesehen ist, so können gebondete Drähte zwischen den Kontaktflächen auf dem Sensorchip über Kontaktanschlußflächen der Kontaktaußenflächen unmittelbar ohne Bondöffnungen in dem Trägersubstrat in vorteilhafter Weise verbunden sein.

Bei einer weiteren vorteilhaften Ausführungsform der Erfindung sind die Kontaktflächen des Sensorchips und die Kontaktaußenflächen des Trägersubstrats auf einem Rand des Sensorchips bzw. des Trägersubstrats angeordnet, so daß kurze und gleichmäßig beabstandete Bondverbindungen mittels Bonddrähten möglich sind, und damit ein Bonden der auf dem Trägersubstrat vormontierten Sensorchips und der zugeordneten Kontaktaußenflächen schnell, einfach und gleichmäßig realisiert werden kann, da alle Bondverbindungen gleichförmig und gleichlang sind.

In einer weiteren bevorzugten Ausführungsform der Erfindung liegen die Kontaktaußenflächen entlang einer der perforierten Ränder des Trägerbandes. Durch einen derartigen Gehäuseaufbau ist es möglich, Epoxidträgerbänder zu verwenden, wie sie auch in der Chipkartenmodulfertigung einsetzbar sind. Perforierte Trägerbänder zur Chipfertigung an sich sind z.B. aus der EP-A-0 057 253 bekannt. Die Montage der Bauteile mit dem erfindungsgemäßen Gehäuse in entsprechende Endgeräte und -systeme kann als SMT-Montage oder universell mit einer angebrachten Flexschaltung für Steckerkontaktierung erfolgen. Die Perforation der Ränder des Trägerbandes kann dazu mit einer Standardperforation versehen werden, wobei in einer bevorzugten Weiterbildung der Erfindung die Massekontaktfläche des Sensorchips über eine strukturierte Metallbeschichtung auf dem Trägerband mit dem Gehäuserahmen elektrisch verbunden ist, so daß ein geerdeter Masserahmen, der gleichzeitig das Sensorchip erdet verwirklicht werden kann.

Die strukturierte Metallbeschichtung des Trägerbandes kann durch Strukturieren einer Metallkaschierung auf dem Trägerband erfolgen. Bei dieser Strukturierung können gleichzeitig die Massekontaktverbindungen zwischen Gehäuserahmen und Sensorchip und die Verbindungen zu den Außenkontaktflächen vorbereitet sein. Dazu weist die strukturierte Metallbeschichtung vorzugsweise von der Innenseite des Gehäuserahmens zur Außenseite des Gehäuserahmens führende Kontaktaußenflächen auf, die innerhalb des Gehäuserahmens mit Bonddrähten versehen sind und außerhalb des Gehäuserahmens frei zugänglich für weitere Steckverbindungen sind.

Um in vorteilhafter Weise einen Kurzschluß der Kontaktaußenflächen zu vermeiden, ist der elektrisch leitende Gehäuserahmen in dem Bereich der Kontaktaußenflächen mit einem isolierenden Klebstoff auf dem Substratträger befestigt und in den übrigen Bereich des Substratträgers über einen leitenden Klebstoff elektrisch mit der Massekontaktfläche des Sensorchips verbunden. Mit dieser Variation in der Klebstoffart können alle Bereiche des Gehäuserahmens auf der unterschiedlich strukturierten Metallbeschichtung des Trägersubstrats fixiert werden.

Der Gehäuserahmen kann im wesentlichen einen Masseschutzring um den Sensorchip bilden oder gleichzeitig für die Weitermontage in einem Gerät oder System vorbereitet sein. Dazu ist der Gehäuserahmen aus einem Masserahmen mit Montageöffnungen aufgebaut, wobei dieser Masserahmen breit und stabil genug um den Sensorchip angebracht ist, so daß, ohne das Sensorchip mechanisch zu belasten, der Masserahmen in vorteilhafter Weise über die Montageöffnungen an ein Endgerät oder ein -system angeschraubt werden kann.

Um die Sicherheit für das Sensorchip weiter zu erhöhen, kann dieses vorzugsweise außerhalb der Fingerabdruckprüfflächen mit einer leitenden Zusatzabdeckung abgedeckt werden. Diese Zusatzabdeckung überbrückt den Abstand zwischen den Rändern des Sensorchips und dem Masserahmen. In einer weiteren bevorzugten Ausführungsform der Erfindung kann die Fingerabdruckfläche auf dem Sensorchip eine rahmenförmige Metallbeschichtung aufweisen, die vorzugsweise über die Zusatzabdeckung auf Masse gelegt werden kann, so daß außerhalb der Fingerabdruckprüffläche das Sensorchip durch eine abdeckende Masseabdekkung geschützt ist.

Vorzugsweise können beide Funktionen des Gehäuses, nämlich einen Gehäuserahmen als Masserahmen zur Verfügung zu stellen und eine Masseabdeckung zu bilden, durch ein einziges Tiefziehteil erfüllt werden. Ein derartiges Tiefziehteil wird wie eine Tasse oder eine Schüssel, die keinen Boden aufweist, über das Sensorchip gestülpt, so daß die Fingerabdruckprüffläche im offenen Bodenbereich der Tasse oder Schüssel freibleibt.

In einer weiteren bevorzugten Ausführungsform der Erfindung kann das Trägerband und/oder der Masserahmen des Gehäuses die für die Funktionsfähigkeit des Sensorchips erforderlichen Stützkondensatoren aufweisen, die damit geschützt durch das Trägerband und/oder durch den Gehäuserahmen für die Montage in einem Gerät oder System zur Verfügung stehen.

Das Trägerband kann in einer bevorzugten Ausführungsform der Erfindung als Endlosband ausgebildet sein und aus einer Polimidfolie bestehen. In weiteren bevorzugten Ausführungsformen wird das Trägersubstrat auch aus Epoxidharz hergestellt oder besteht aus einem flexiblen Polymer. Dieses hat den Vorteil, daß die Sensorchips mit dem montierten Gehäuse in Endlosbändern oder Nutzen montiert und getestet werden können und die Modulmontage nun auf Montagelinien durchgeführt werden kann, die auch für Chipkartenmodule nutzbar sind. Darüber hinaus kann mit diesem auf Endlosbändern montierten Gehäuse ein Einbau der Sensoren beim Herstellungsprozeß der Endgeräte und -systeme leicht integriert werden und der Einbau dementsprechend kostengünstig durchgeführt werden.

Die Verbindung von Flexschaltungen der Gehäuse zu den Endgeräten und -systemen kann über Steckverbindungen wie Nullkraftstecker oder über eine Lötverbindung erfolgen, so daß die Verbindungstechnologie mit dem erfindungsgemäßen Gehäuse vollständig dem kundenspezifischen Herstellungsprozeß angepaßt werden kann. Das gilt auch für die Breite und die Länge und die Form der Anschlüsse auf dem Substratträger. Die obengenannten verschiedenen Varianten des Masserahmens können im Rahmen dieser Erfindung unterschiedlich aufgebaut sein, so daß entweder der Masserahmen durch eine leitfähige feste Abdeckung auf dem Rahmen als Formteil ausgeführt oder elektrisch leitend zum Rahmen oder zum Masseanschluß montiert wird. Der Masserahmen kann aber auch durch eine leitfähige Folie oder eine leitfähige Abdeckmasse auf den Sensorchip aufgebracht werden. Dabei kann die Kontaktierung zum Masseanschluß des Sensorchips über den Rahmen erfolgen.

Das erfindungsgemäße Gehäuse zeichnet sich durch einen einfachen Aufbau auf einem Epoxidträger aus, auf dem der Sensorchip dem Kunden in für die Weiterverarbeitung vorteilhafter Weise angeboten werden kann. Die Besonderheiten, die mit der von außen zugänglichen aktiven Fläche eines biometrischen Sensorgehäuses und dem Masserahmen mit dieser Erfindung bereitgestellt werden, vereinfachen die Herstellung der Endgeräte und -systeme.

Ein Verfahren zur Herstellung eines biometrischen Sensorgehäuses mit Sensorchip, frei zugänglicher Fingerabdruckprüffläche auf dem Sensorchip, Trägersubstrat und Außenkontaktflächen weist folgende Verfahrensschritte auf:
a) Bereitstellen eines Sensorchips, wobei eine Massekontaktfläche die Unterseite des Sensorchips bildet,
b) Strukturieren einer Metallbeschichtung auf einem Trägersubstrat zu Masseanschlußflächen im Bereich des Sensorchips und Masseanschlußflächen für einen Gehäuserahmen sowie zu Kontaktaußenflächen,
c) Perforieren der Ränder des Trägersubstrats,
d) Aufbringen des Sensorchips mit seiner Massekontaktfläche auf die strukturierte Metallbeschichtung im Bereich der Masseanschlußfläche für das Sensorchip,
e) Bonden der Kontaktflächen auf dem Sensorchip mit den Kontaktaußenflächen auf der strukturierten Metallbeschichtung,
f) Aufbringen des Gehäuserahmens auf die strukturierte Metallbeschichtung im Bereich der Masseanschlußfläche für den Gehäuserahmen,
g) selektives Versiegeln der Bondverbiridungen mittels einer Kunststoff-Vergußmasse.

Ein derartiges Verfahren hat den Vorteil, daß es für die Massenherstellung von Gehäusen für biometrische Sensorchips geeignet ist und eine unmittelbare Weiterverarbeitung der Gehäuse mit biometrischen Sensorchips für die Herstellung von Bankautomaten, Handys und/oder Computern, die einen Zugang über einen Fingerabdruck freigeben, ermöglicht.

In einer bevorzugten Durchführungsform des Verfahrens wird ein Abdecken der Sensorfläche, die nicht der Fingerabdruckprüfung dient, mit einer Gehäuseabdeckung durchgeführt. Mit einer derartigen Gehäuseabdeckung wird in vorteilhafter Weise der Randbereich des Sensorchips hermetisch gegen Außeneinflüsse abgeschlossen, so daß lediglich die Fingerabdruckprüffläche frei zugänglich bleibt.

In einer weiteren bevorzugten Durchführung des Verfahrens wird ein Sensorchip mit einer rahmenförmigen Massekontaktfläche auf der Oberseite des Sensorchips bereitgestellt, so daß nicht nur die Unterseite des Sensorchips auf Masse gelegt werden kann, sondern eine zusätzliche Massekontaktfläche auch auf der Oberseite des Sensorchips bereitsteht, um mit dem Masserahmen des Gehäuses kurzgeschlossen zu werden. Dieses hat den Vorteil, daß elektrostatische Entladungen mit größerer Sicherheit von der zentralen freiliegenden Fingerabdruckprüffläche abgehalten werden. Damit kann auch gleichzeitig die Lebensdauer des Sensorchips in dem erfindungsgemäßen Gehäuse erhöht werden.

Dazu wird vorzugsweise die nicht der Fingerabdruckprüfung dienende Fläche mit einer elektrisch leitenden Gehäusezusatzabdeckung versehen, die mit dem Massekontaktanschluß auf der Oberseite des Sensorchips verbunden wird. Somit bildet das gesamte Gehäuse einschließlich Abdeckung einen auf Masse liegenden Schutz für die empfindliche Fingerabdruckprüfungsfläche des Sensorchips. Die sich zwischen Gehäuserahmen und Gehäusezusatzabdeckung bildenden Hohlräume werden in einem bevorzugten Verfahren mit einem zusätzlichen Verfahrensschritt mit Füllstoff aus Kunststoff aufgefüllt. Dieses hat den Vorteil, daß mit diesem Verfahrensschritt die Schwingfestigkeit des Gehäuses wesentlich erhöht werden kann.

In einer weiteren bevorzugten Ausführungsform der Erfindung erfolgt die Strukturierung der Metallbeschichtung auf dem Trägersubstrat mittels Laserabtrag. Bei dieser Verfahrensvariante kann im Durchlaufverfahren das Trägerband und die darauf befindliche Metallbeschichtung entsprechend den Anforderungen an das Gehäuse für einen biometrischen Sensor präzise und schnell zugeschnitten werden.

In einer alternativen bevorzugten Verfahrensvariante wird die Strukturierung der Metallbeschichtung mittels eines Photolithographieverfahrens erreicht. Dazu wird eine photoempfindliche Schicht auf die Metallbeschichtung des Trägersubstrats aufgebracht, diese Schicht dann in einem Belichtungsschritt teilweise ausgehärtet, so daß in einem weiteren Entwicklungsschritt die nicht belichteten Stellen ausgelöst werden können und das darunter befindliche Metall der Beschichtung mittels eines Ätzvorgangs entfernt werden kann. Abschließend wird die Photolackschicht von dem verbleibenden Metall durch vorzugsweise Plasmaveraschung oder Ionenzerstäubung entfernt. Das Aufbringen einer strukturierenden Schutzschicht über der Metallschicht zum Ätzen einer Struktur kann vorzugsweise auch durch ein Schablonendruckverfahren oder durch ein Siebdruckverfahren erreicht werden.

Das Befestigen des Gehäuserahmens auf dem Substratträger wird vorzugsweise mittels Klebetechnik durchgeführt, wobei der Klebstoff elektrisch leitend oder isolierend auf dem Trägersubstrat bzw. auf der Metallbeschichtung aufgebracht wird. Soweit die strukturierte Metallbeschichtung einen Kurzschluß mit der Massekontaktfläche des Sensorchips herstellt, wird zur Befestigung des Gehäuserahmens ein elektrisch leitender Kleber eingesetzt, um in Verbindung mit dem Masseanschluß einen Masserahmen zum Schutz der Fingerabdruckprüffläche des Sensorchips herzustellen. Als elektrisch leitende Verbindung zwischen dem Masserahmen und der Metallbeschichtung des Trägersubstrats wird vorzugsweise auch ein Lötverfahren eingesetzt, bei dem eine niedrigschmelzende Lotbeschichtung zusätzlich auf die Metallbeschichtung im Bereich des Gehäuserahmen auf das Trägersubstrat aufgebracht wird.

Die Erfindung wird nun durch bevorzugte Ausführungsformen anhand der beigefügten Zeichnungen näher erläutert.
- Figur 1: zeigt eine prinzipielle Querschnittsansicht eines Gehäuses für biometrische Sensorchips gemäß einer ersten Ausführungsform der Erfindung.
- Figur 2: zeigt eine Draufsicht auf das Gehäuse mit Sensorchip der Figur 1.
- Figur 3: zeigt eine Draufsicht auf ein Trägerband mit mehreren Gehäusen der Figur 1.
- Figur 4: zeigt eine prinzipielle Querschnittsansicht eines Gehäuses für biometrische Sensorchips gemäß einer zweiten Ausführungsform der Erfindung.
- Figur 5: zeigt eine Draufsicht auf das Gehäuse mit Sensorchip der Figur 4.
- Figur 6: zeigt einen prinzipiellen Querschnitt eines Gehäuses für biometrische Sensorchips gemäß einer dritten Ausführungsform der Erfindung.
- Figur 7: zeigt eine prinzipielle Querschnittsansicht eines Gehäuses für biometrische Sensorchips gemäß einer vierten Ausführungsform der Erfindung.
- Figur 8: zeigt eine Draufsicht auf ein Trägerband mit mehreren Gehäusen der Figur 7.
- Figur 9: zeigt eine prinzipielle Querschnittsansicht eines Gehäuses für biometrische Sensorchips gemäß einer fünften Ausführungsform der Erfindung.
- Figur 10: zeigt eine prinzipielle Querschnittsansicht eines Gehäuses für biometrische Sensorchips gemäß einer sechsten Ausführungsform der Erfindung.

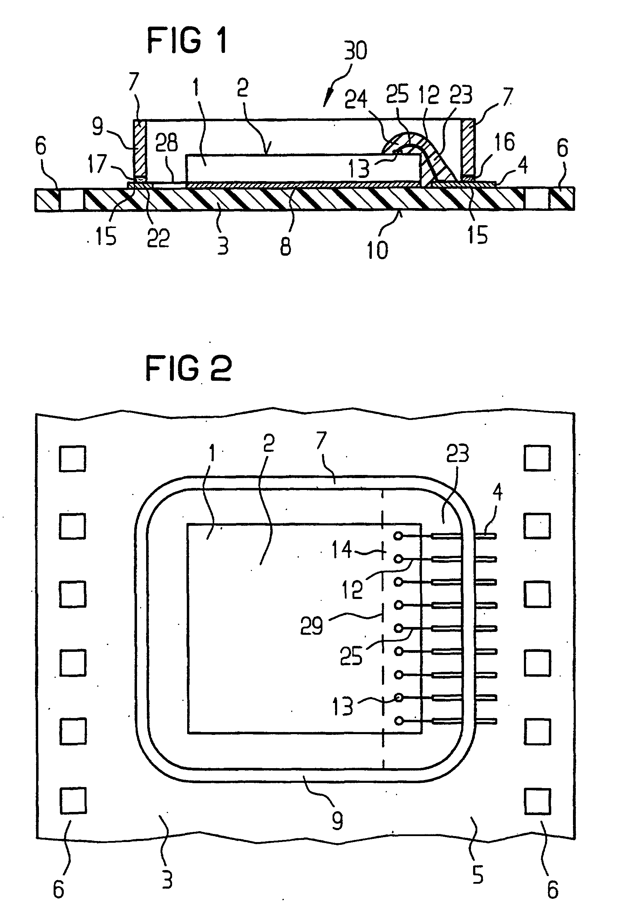

Figur 1 zeigt eine prinzipielle Querschnittsansicht eines Gehäuses 30 für biometrische Sensorchips 1 gemäß einer ersten Ausführungsform der Erfindung. Das Gehäuse läßt eine frei zugängliche Fingerabdruckprüffläche 2 auf dem Sensorchip 1 frei, so daß ein Benutzer seine Fingerspitze zur Prüfung einer Zugangsberechtigung zu entsprechend abgesicherten Geräten und Serviceleistungen sowie Systemen und Objekten prüfen lassen kann. Das Sensorchip ist in einem Gehäuserahmen 7 angeordnet, der nach oben offen ist und auf einer Metallbeschichtung 15 steht, mit der er über einen leitenden Klebstoff 17 elektrisch verbunden ist. Das Sensorchip ist auf der gleichen Metallbeschichtung 15 vorzugsweise mit einem leitenden Kleber mit seiner Massekontaktfläche 8 auf der Unterseite des Sensorchips 1 montiert und über eine metallische Leitung 28 mit dem Gehäuserahmen 7 elektrisch verbunden, so daß ein Masserahmen 9 gebildet wird, der das Sensorchip vor elektrischer Entladung schützt.

Ein derartig aufgebauter Masserahmen verlängert gleichzeitig in vorteilhafter Weise die Lebensdauer des Sensorchips, da Fingerspitzen häufig derart stark elektrostatisch aufgeladen sind, daß sich Funkenentladungen ausbilden, die das Sensorchips zerstören können. Derartige Funkenentladungen werden jedoch bei dem erfindungsgemäßen Gehäuse über den Masserahmen 7 abgeleitet. Die Metallschicht 15 auf dem Trägersubstrat 3 ist strukturiert und weist im Bereich der Bondverbindung 25 Kontaktaußenflächen 4 auf, die elektrisch über Bonddrähte 12 mit Kontaktflächen 13 auf dem Chip verbunden sind. Der Gehäuserahmen 7, der aus einem leitenden Material oder einem metallbeschichteten Nichtleiter besteht, ist in diesem Ausführungsbeispiel im Bereich der Kontaktaußenflächen 4 mit einem isolierenden Kleber 16 mit dem Trägersubstrat verbunden. Die Klebstoffnaht 16 des Gehäuserahmens 7 im Bereich der Kontaktaußenflächen 4 besteht aus einem isolierenden Klebstoff. Damit wird gewährleistet, daß die Kontaktaußenflächen nicht kurzgeschlossen werden.

Die Bondverbindungen 25 werden mit einer Kunststoff-Vergußmasse vor mechanischer Beschädigung geschützt, so daß ein Randbereich innerhalb des Gehäuserahmens 7 vollständig mit Kunststoff-Vergußmasse 24 aufgefüllt ist. Das Trägersubstrat 3 ist ein an den Rändern 6 perforiertes Trägerband, wie es deutlich die Draufsicht der Figur 2 zeigt. Die Kunststoff-Vergußmasse 24 ist in dieser Draufsicht weggelassen bzw. durch eine gestrichelte Linie angedeutet, um die Anordnung der Kontaktflächen 113 auf dem Sensorchip 1 abbilden zu können und die Anordnung der Bondverbindungen 25 im Anschlußbereich 23 des Gehäuses für biometrische Sensorchips 1 zu zeigen. Die Kontaktaußenflächen liegen bei diesem Ausführungsbeispiel in einer Reihe parallel zur Perforation des Trägerbandes 5. Der metallische Rahmen 7 umgibt das Sensorchip 1 in einem vorbestimmten Abstand und ist, wie oben erwähnt, mit der Massekontaktfläche 8 des Sensorchips 1, wie in Figur 1 gezeigt, über die strukturierte Metallbeschichtung 15 verbunden .

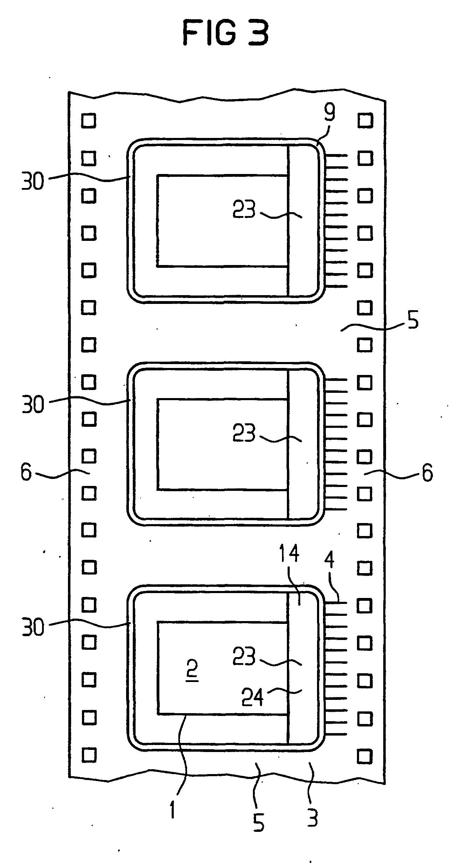

Figur 3 zeigt eine Draufsicht auf ein Trägerband 5 mit mehreren Gehäusen 30 der Figur 1. Das Trägerband 5, das an den Rändern 6 perforiert ist, ermöglicht eine kontinuierliche und fortschreitende automatisierte Führung des Trägersubstrats von einer Bearbeitungsstation zur nächsten, so daß der Zusammenbau des Gehäuses mit Sensorchip sowie das Bonden der Verbindungen schnell und rationell durchgeführt werden kann. Dazu wird in dieser Ausführungsform ein Epoxidträgerband verwendet, wie es auch in der Chipkartenmodulfertigung einsetzbar ist. Somit können standardisierte Bänder Verwendung finden, wodurch die Herstellungskosten weiter verringert werden. Außerdem kann das Band in dieser Form an die weiterverarbeitenden Gerätehersteller geliefert werden. Deutlich ist mit Figur 3 zu erkennen, daß der Fingerabdruckprüfbereich frei zugänglich ist und nur der Abdeckbereich 14 für die Fingerabdruckprüffläche nicht zur Verfügung steht, weil in diesem Randbereich 23 die unterschiedlichen Bondverbindungen zu den Kontaktaußenflächen 4 angeordnet sind.

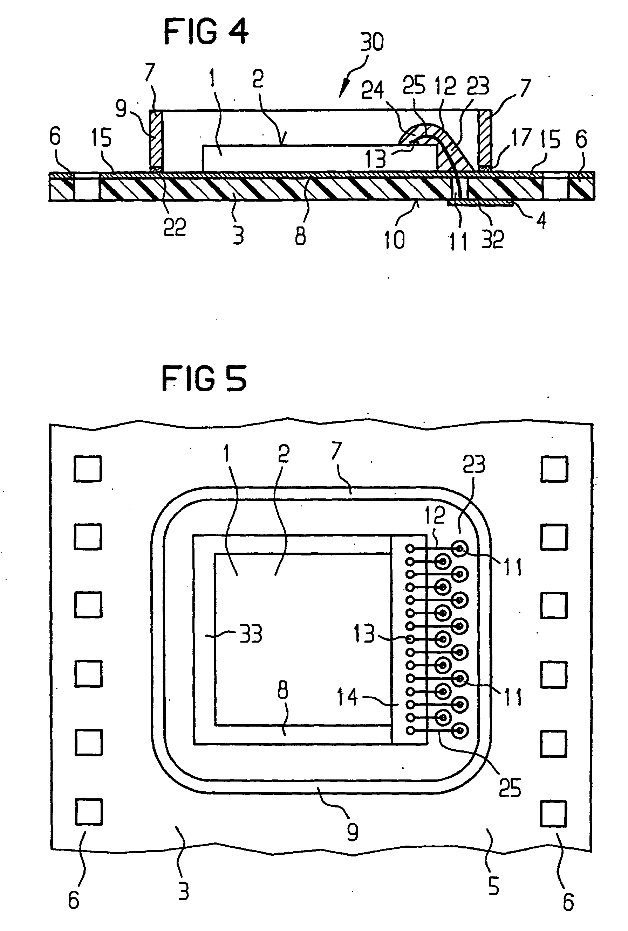

Figur 4 zeigt eine prinzipielle Querschnittsansicht eines Gehäuses für biometrische Sensorchips gemäß einer zweiten Ausführungsform der Erfindung. Während in Figur 1 die Kontaktaußenflächen 4 auf der Sensorchipseite des Trägersubstrats 3 angeordnet sind, werden bei der zweiten Ausführungsform, wie sie im Querschnitt in Figur 4 zu sehen ist, die Außenkontaktflächen 4 auf der Unterseite des Trägerbandes angeordnet. Die dort aufgebrachte Metallschicht 32 überbrückt Bondöffnungen 11 in dem Trägersubstrat 3, durch die Bonddrähte 12 mit der Metallbeschichtung 32 verbunden sind. Diese Bonddrähte 12 verbinden die Kontaktflächen 13 auf dem Halbleiterchip mit den Außenkontaktflächen 4 auf der Unterseite 10 des Trägersubstrats 3 in dieser Ausführungsform.

Im Gegensatz zum Ausführungsbeispiel der Figur 1 kann der Gehäuserahmen.7 in dem Ausführungsbeispiel der Figur 4 durchgängig mit einem leitenden Klebstoff auf der Metallbeschichtung des Substratträgers 3 montiert werden. Diese zweite Ausführungsform hat den Vorteil, daß die Metallbeschichtung 15 des Substratträgers 3 nicht strukturiert werden muß, so daß ein komplexer Verfahrensschritt, nämlich der der Strukturierung der Metallbeschichtung 15 eingespart werden kann.

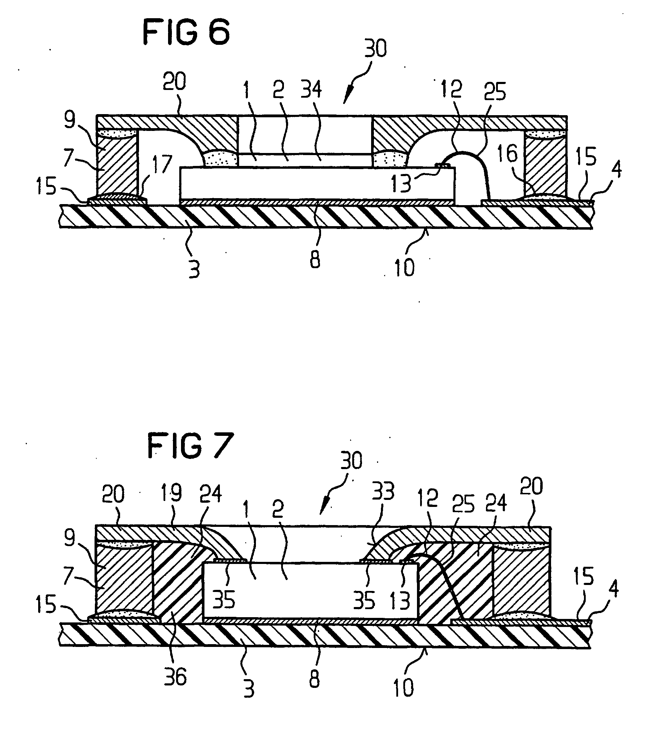

Figur 5 zeigt eine Draufsicht auf das Gehäuse 30 der Figur 4. In dieser Draufsicht wird neben der Reihe 13 der Kontaktflächen am Rand des Sensorchips 1 eine rahmenförmige Massekontaktfläche 33 im Randbereich der Oberfläche des Sensorchips gezeigt. Diese rahmenförmige Massekontaktfläche 33 erhöht zusätzlich die Zuverlässigkeit des Sensorchips und wird in einer bevorzugten Ausführungsform der Erfindung mit dem Gehäuserahmen elektrisch verbunden. Darüber hinaus zeigt Figur 5, daß die Beschichtung des Trägerbandes 5 durchgängig sein kann, da für jeden der Bondverbindungen eine Durchgangsbohrung zur Unterseite des Trägerbandes zur Verfügung steht, auf der die Kontaktaußenflächen 4 angeordnet sind. Die Metallbeschichtung des Trägerbandes muß bei dieser Ausführungsform nicht strukturiert werden, dafür sind jedoch an geeigneter Stelle Bondlöcher vorzusehen. Ferner kann mit dieser Ausführungsform der Erfindung der Masserahmen 7 direkt und geschlossen mit einem leitenden Kleber 17 oder mit einer Lötverbindung auf der Metallbeschichtung des Trägerbandes fixiert werden.

Figur 6 zeigt eine prinzipielle Querschnittsansicht eines Gehäuses 30 für biometrische Sensorchips 1 gemäß einer dritten Ausführungsform der Erfindung. In dieser dritten Ausführungsform besteht das Gehäuse 30 aus einem Gehäuserahmen, der mit einem leitenden Klebstoff 17 an der Metallbeschichtung befestigt ist und mit einem isolierenden Klebstoff 16 im Bereich der Kontaktaußenflächen 4 fixiert ist. Alternativ zu den Ausführungsformen der Figuren 1 bis 5 wird in dieser Ausführungsform zusätzlich über den Sensorchip 1 eine Masse- und Gehäuseabdeckung 20 angeordnet, die nur noch die Fingerabdruckprüffläche freiläßt. Mittels einer Zusatzdichtung 34 wird der Hohlraum zwischen Gehäuserahmen 7 und Fingerabdruckprüffläche 2 mit einer hermetisch abschließenden Dichtung versehen. Die Abdeckung 20 kann auf den Gehäuserahmen 7 gelötet werden, so daß die Abdeckung 20 und der Gehäuserahmen 7 ein Massegehäuse bilden, das den Sensorchip sowohl mechanisch als auch elektrisch schützt.

Figur 7 zeigt eine prinzipielle Querschnittsansicht eines Gehäuses 30 für biometrische Sensorchips 1 gemäß einer vierten Ausführungsform der Erfindung. Diese vierte Ausführungsform weist zwei Verbesserungen gegenüber der Ausführungsform 6 auf. Einerseits hat die elektrisch leitende Zusatzabdeckung 19 unmittelbaren Kontakt mit einer rahmenförmigen Massekontaktfläche 33, die auf dem Halbleiterchip angeordnet ist, so daß eine Masseabdeckun 20 die Fingerabdruckprüffläche umgibt. Außerdem sind die Hohlräume zwischen leitender Abdeckung und leitendem Gehäuserahmen mit einem Füllstoff 36 aufgefüllt, was die Stabilität und die Schwingfestigkeit des Gehäuses mit biometrischem Sensorchip erhöht.

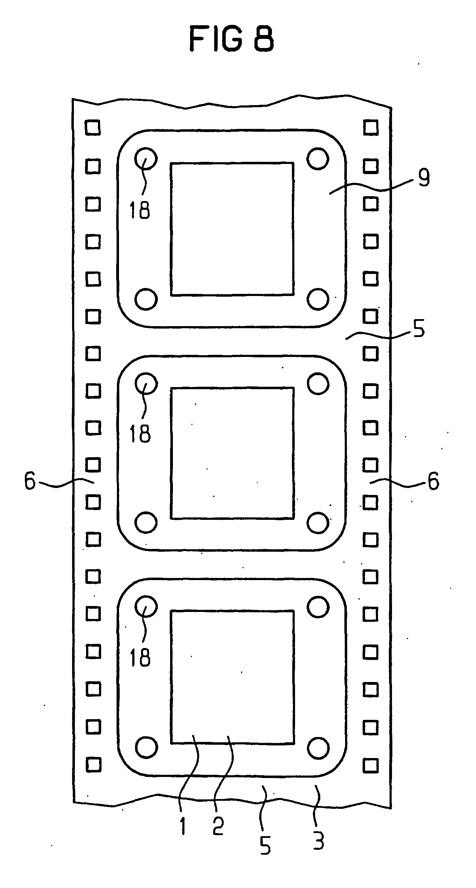

Figur 8 ist eine Draufsicht auf eine Mehrzahl von Gehäusen der Figur 7, wobei die Fingerabdruckprüffläche 2 mit einem Masserand und einer Zusatzabdeckung dargestellt ist und der Masserahmen 9 zusätzlich Montageöffnungen 18 aufweist, die ein Befestigen des Gehäuses an einem Endgerät oder -system mittels einfacher Schraubtechnik ermöglichen.

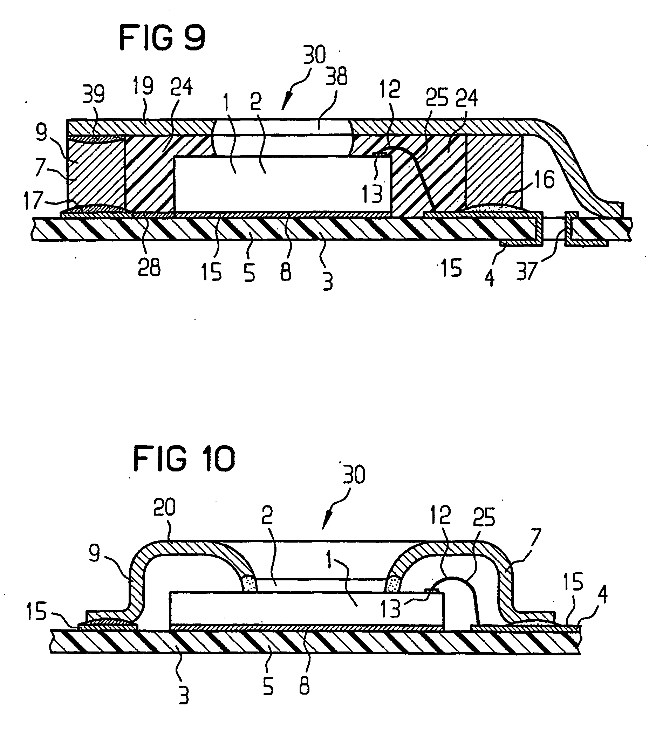

Figur 9 zeigt eine prinzipielle Querschnittsansicht eines Gehäuses 30 für biometrische Sensorchips 1 gemäß einer fünften Ausführungsform der Erfindung. Bei dieser fünften Ausführungsform der Erfindung ist wiederum eine Abdeckung 19, die elektrisch leitend ist, zu sehen, jedoch wird diese Abdeckung 19 über das Sensorchip 1 geführt, wobei eine zentrale Öffnung 38 für einen Zugriff auf die Fingerabdruckprüffläche 2 vorgesehen ist. In dieser Ausführungsform weist das Sensorchip 1 keine rahmenförmige Massekontaktfläche auf seiner Oberfläche, wie in Figur 7, auf und der Zwischenraum zwischen Gehäuserahmen und Gehäuseabdeckung und Sensorchip ist mit Füllstoff aufgefüllt. Die Verbindung der Massekontaktfläche 8 mit der Abdeckung 19 wird über die strukturierte Metallbeschichtung 15 des Trägersubstrats 3, den leitenden Klebstoff 17, den Gehäuserahmen und den leitenden Klebstoff 39 erreicht, wobei die Massekontaktfläche 8 des Sensorchips 1 über die Verbindungsleitung 28 der Metallbeschichtung 15 mit dem Gehäuserahmen 7 verbunden ist. Ein weiterer Unterschied der hier dargestellten fünften Ausführungsform gegenüber den bisher beschriebenen Ausführungsformen ist in dem Durchkontakt 37 zu sehen, der den Außenkontaktanschluß zu der Außenkontaktfläche 4, die auf der Unterseite des Trägersubstrats 3 angeordnet ist, herstellt.

Figur 10 zeigt eine prinzipielle Querschnittsansicht eines Gehäuses 30 für biometrische Sensorchips 1 gemäß einer sechsten Ausführungsform der Erfindung. Bei dieser Ausführungsform besteht die Gehäuseabdeckung 19 und der Gehäuserahmen 7 aus einem einstückigen Tiefziehteil, das topfartig über das Sensorchip 1 gestülpt ist. Diese Ausführungsform hat den Vorteil, daß der Zusammenbau stark vereinfacht wird, da weniger Komponenten vorzubereiten sind, und zum anderen hat es den Vorteil, daß mit relativ einfachen Mitteln die Massenherstellung von Gehäusen für Sensorchips kostengünstig realisiert werden kann.

### Bezugszeichenliste

- 1: Sensorchip
- 2: Fingerabdruckfläche
- 3: Trägersubstrat
- 4: Kontaktaußenflächen
- 5: Trägerband
- 6: perforierte Ränder
- 7: Gehäuserahmen
- 8: Massekontaktfläche
- 9: Masserahmen
- 10: Unterseite des Trägersubstrats
- 11: Bondöffnungen
- 12: Bonddrähte
- 13: Kontaktflächen
- 14: Randbereich des Sensorchips
- 15: Metallbeschichtung
- 16: isolierender Klebstoff
- 17: leitender Klebstoff
- 18: Montageöffnungen
- 19: Zusatzabdeckung
- 20: Masse- und Gehäuseabdeckung
- 21: Unterseite des Sensorchips
- 22: strukturierte Metallbeschichtung
- 23: Anschlußbereich
- 24: Kunststoff-Vergußmasse
- 25: Bondverbindung
- 26: Oberseite des Sensorchips
- 27: Füllmasse
- 28: metallische Leitung
- 29: gestrichelte Linie
- 30: Sensorgehäuse
- 31: Perforationslöcher
- 32: Metallschichten
- 33: rahmenförmige Massekontaktfläche
- 34: Zusatzdichtung
- 35: Masselektrode
- 36: Füllstoff
- 37: Durchkontakt
- 38: zentrale Öffnung
- 39: leitender Klebstoff

## Patentansprüche

1. Biometrische Sensorvorrichtung mit einem biometrischen Sensorchip (1), einem Gehäuse für des biometrische Sensorchip (1), mit frei zugänglicher Fingerabdruckprüffläche (2) auf dem Sensorchip (1), einem Trägersubstrat (3) und Außenkontaktflächen (4) auf dem Trägersubstrat (3), wobei das Trägersubstrat (3) ein Trägerband (5) mit perforierten Rändern (6) ist, auf dem die Kontaktaußenflächen (4) teilweise außerhalb eines Gehäuserahmens (7) angeordnet sind, und das Sensorchip (1) innerhalb des Gehäuserahmens (7) positioniert ist, wobei eine die Unterseite des Sensorchips bildende Massekontaktfläche (8) des auf dem Trägersubstrat aufliegenden Sensorchips (1) mit dem Gehäuserahmen (7) zu einem Masserahmen (9) verbunden ist.

2. Vorrichtung nach Anspruch 1,
**dadurch gekennzeichnet, daß**
die Kontaktaußenflächen (4) auf der Unterseite (10) des Trägersubstrats (3) angeordnet sind und über Bondöffnungen (11) in dem Trägersubstrat (3) und Bonddrähte (12) mit den Kontaktflächen (13) auf dem Sensorchip (1) verbunden sind.

3. Vorrichtung nach Anspruch 1 oder 2,
**dadurch gekennzeichnet, daß**
die Kontaktaußenflächen (4) auf der Chipseite des Trägersubstrats (3) angeordnet sind.

4. Vorrichtung nach einem der vorhergehenden Ansprüche,
**dadurch gekennzeichnet, daß**
die Kontaktflächen (13) der Sensorchips (1) und die Kontaktaußenflächen (4) des Trägersubstrats auf einem Rand (14) des Sensorchips (1) bzw. Trägersubstrats (3) angeordnet sind, der zu einer der perforierten Ränder (6) des Trägerbandes (5) zeigt.

5. Vorrichtung nach einem der vorhergehenden Ansprüche,
**dadurch gekennzeichnet, daß**
eine Massekontaktfläche (8) des Sensorchips (1) über eine strukturierte Metallbeschichtung (15) auf dem Trägerband (5) aus isolierendem Material mit dem Gehäuserahmen (7) elektrisch verbunden ist.

6. Vorrichtung nach Anspruch 5,
**dadurch gekennzeichnet, daß**
die strukturierte Metallbeschichtung (15) von der Innenseite des Gehäuserahmens (7) nach außerhalb des Gehäuserahmens (7) führende Kontaktaußenflächen (4) aufweist, die innerhalb des Gehäuserahmens (7) mit Bonddrähten (12) versehen sind und außerhalb des Gehäuserahmens (7) frei zugänglich sind.

7. Vorrichtung nach Anspruch 5 oder Anspruch 6, **dadurch gekennzeichnet, daß** der Gehäuserahmen (7) im Bereich der Kontaktaußenflächen (4) mit einem isolierenden Klebstoff (16) auf dem Substratträger (3) befestigt ist und in den übrigen Bereichen des Substratträgers (3) über einen leitenden Klebstoff (17) und eine Metallbeschichtung (15) elektrisch mit der Massekontaktfläche (8) des Sensorchips (1) verbunden ist.

8. Vorrichtung nach einem der vorhergehenden Ansprüche,
**dadurch gekennzeichnet, daß**
der Gehäuserahmen (7) aus einem Masserahmen (9) mit Montageöffnungen (18) aufgebaut ist.

9. Vorrichtung nach einem der vorhergehenden Ansprüche,
**dadurch gekennzeichnet, daß**
das Sensorchip (1) außerhalb der Fingerabdruckprüffläche (2) mit einer Zusatzabdeckung (19) abgedeckt ist.

10. Vorrichtung nach einem der vorhergehenden Ansprüche,
**dadurch gekennzeichnet, daß** das Gehäuse (30) eine die Flächen außerhalb der Fingerabdruckprüffläche (2) abdeckende Masseabdeckung (20) aufweist.

11. Vorrichtung nach einem der vorhergehenden Ansprüche,
**dadurch gekennzeichnet, daß**
das Gehäuse (30) aus einem Tiefziehteil besteht, das den Masserahmen (9) und eine Masseabdeckung (20) aufweist.

12. Vorrichtung nach einem der vorhergehenden Ansprüche,
**dadurch gekennzeichnet, daß**
auf dem Trägerband Stützkondensatoren montiert sind.

13. Vorrichtung nach einem der vorhergehenden Ansprüche,
**dadurch gekennzeichnet, daß**
das Trägersubstrat (3) ein Endlosband ist.

14. Vorrichtung nach einem der vorhergehenden Ansprüche,
**dadurch gekennzeichnet, daß**
das Trägersubstrat (3) aus Epoxidharz besteht.

15. Vorrichtung nach einem der Ansprüche 1 bis 13,
**dadurch gekennzeichnet, daß**
das Trägersubstrat (3) flexibel ist und aus einem Polymer besteht.

16. Verfahren zur Herstellung einer biometrischen Sensorvorrichtung (30) mit einem Sensorchip (1), frei zugänglicher Fingerabdruckprüffläche (1) auf dem Sensorchip (1), Trägersubstrat (3) und Außenkontaktflächen (4), das folgende Verfahrensschritte aufweist:
a) Bereitstellen eines Sensorchips (1), wobei eine Massekontaktfläche (8) die Unterseite (21) des Sensorchips (1) bildet,
b) Strukturieren einer Metallbeschichtung (15, 22) auf einem Trägersubstrat (3) zu Masseanschlußflächen im Bereich des Sensorchips (1) und eines Gehäuserahmens (7) sowie zu Kontaktaußenflächen,
c) Perforieren der Ränder (6) des Trägersubstrats (3),
d) Aufbringen des Sensorchips (1) mit seiner Massekontaktfläche auf die strukturierte Metallbeschichtung (15, 22) im Bereich der Masseanschlußfläche für das Sensorchip,
e) Bonden der Kontaktflächen (13) auf dem Sensorchip (1) mit den Kontaktaußenflächen (4) auf dem Trägersubstrat (3),
f) Aufbringen des Gehäuserahmens (7) auf die strukturierte Metallbeschichtung (15, 22) im Bereich der Masseanschlußflächen für den Gehäuserahmen,
g) selektives Versiegeln der Bondverbindungen mittels einer Kunststoff-Vergußmasse.

17. Verfahren nach Anspruch 16,
**dadurch gekennzeichnet, daß**
nach dem Versiegeln ein Abdecken der Sensorchipfläche (1), die nicht der Fingerabdruckprüfung dient, mit einer Gehäuseabdeckung (20) durchgeführt wird.

18. Verfahren nach Anspruch 16 oder 17,
**dadurch gekennzeichnet, daß**
ein Sensorchip (1) mit einer rahmenförmigen Massekontaktfläche (33) auf der Oberseite (26) des Sensorchips (1) bereitgestellt wird.

19. Verfahren nach einem der Ansprüche 16 bis 18,
**dadurch gekennzeichnet, daß**
die Sensorflächen (1), die nicht der Fingerabdruckprüfung dienen, mit einer elektrisch leitenden Gehäusezusatzabdeckung (19) abgedeckt werden, die mit einer rahmenförmigen Massekontaktfläche (33) auf der Oberseite (26) des Substratchips (1) elektrisch verbunden wird.

20. Verfahren nach einem der Ansprüche 16 bis 19,
**dadurch gekennzeichnet, daß**
die Zwischenräume zwischen dem Gehäuserahmen (7) und den Seiten der Sensorchips (1) mit einem Füllstoff (27) aus Kunststoff aufgefüllt werden.

21. Verfahren nach einem der Ansprüche 16 bis 20,
**dadurch gekennzeichnet, daß**
die Strukturierung der Metallbeschichtung (15) mittels Laserabtrag erfolgt.

22. Verfahren nach Anspruch 16 bis 20,
**dadurch gekennzeichnet, daß**
die Strukturierung der Metallbeschichtung (15) mit einem Photolithographieverfahren erfolgt.

23. Verfahren nach einem der Ansprüche 16 bis 20,
**dadurch gekennzeichnet, daß**
das Strukturieren der Metallbeschichtung (15) mittels Siebdruckverfahren oder Schablonendruckverfahren erfolgt.

24. Verfahren nach einem der Ansprüche 16 bis 23,
**dadurch gekennzeichnet, daß**
das Aufbringen des Gehäuserahmens (7) mittels Klebetechnik erfolgt.

25. Verfahren nach einem der Ansprüche 16 bis 23,
**dadurch gekennzeichnet, daß**
das Aufbringen des Gehäuserahmens (7) mittels Lötverfahren erfolgt.

## Claims

1. Biometric sensor apparatus having a biometric sensor chip (1), a housing for the biometric sensor chip (1), having a freely accessible fingerprint checking area (2) on the sensor chip (1), having a mount substrate (3) and outer contact surfaces (4) on the mount substrate (3), with the mount substrate (3) being a mounting strip (5) with perforated edges (6), on which the contact outer surfaces (4) are arranged partially outside a housing frame (7), and the sensor chip (1) is positioned within the housing frame (7), with an earth contact surface (8), forming the lower face of the sensor chip, of the sensor chip (1) located on the mount substrate being connected to the housing frame (7) to form an earth frame (9).

2. Apparatus according to Claim 1,
**characterized in that**
the contact outer surfaces (4) are arranged on the lower face (10) of the mount substrate (3) and are connected to the contact surfaces (13) on the sensor chip (1) via bonding openings (11) in the mount substrate (3) and bonding wires (12).

3. Apparatus according to Claim 1 or 2,
**characterized in that**
the contact outer surfaces (4) are arranged on the chip side of the mount substrate (3).

4. Apparatus according to one of the preceding claims,
**characterized in that**
the contact surfaces (13) of the sensor chips (1) and the contact outer surfaces (4) of the mount substrate are arranged on an edge (14) of the sensor chip (1) or of the mount substrate (3) which points to one of the perforated edges (6) of the mounting strip (5).

5. Apparatus according to one of the preceding claims,
**characterized in that**
an earth contact surface (8) of the sensor chip (1) is electrically connected to the housing frame (7) via a structured metal coating (15) on the mounting strip (5) composed of insulating material.

6. Apparatus according to Claim 5,
**characterized in that**
the structured metal coating (15) has contact outer surfaces (4) which lead from the inside face of the housing frame (7) to outside the housing frame (7), are provided with bonding wires (12) within the housing frame (7), and are freely accessible outside the housing frame (7).

7. Apparatus according to Claim 5 or Claim 6,
**characterized in that**
the housing frame (7) is mounted on the substrate mount (3) in the area of the contact outer surfaces (4) by means of an insulating adhesive (16), and, in the other areas of the substrate mount (3), is electrically connected to the earth contact surface (8) of the sensor chip (1) via a conductive adhesive (17) and a metal coating (15).

8. Apparatus according to one of the preceding claims,
**characterized in that**
the housing frame (7) is formed from an earth frame (9) with mounting openings (18).

9. Apparatus according to one of the preceding claims,
**characterized in that**
the sensor chip (1) is covered by an additional cover (19) outside the fingerprint checking area (2).

10. Apparatus according to one of the preceding claims,
**characterized in that**
the housing (13) has an earth cover (20) which covers the areas outside the fingerprint checking area (2).

11. Apparatus according to one of the preceding claims,
**characterized in that**
the housing (30) is a deep-drawn or thermoformed part, which has the earth frame (9) and an earth cover (20).

12. Apparatus according to one of the preceding claims,
**characterized in that**
energy storage capacitors are mounted on the mounting strip.

13. Apparatus according to one of the preceding claims,
**characterized in that**
the mount substrate (3) is an endless strip.

14. Apparatus according to one of the preceding claims,
**characterized in that**
the mount substrate (3) is composed of epoxy resin.

15. Apparatus according to one of Claims 1 to 13,
**characterized in that**
the mount substrate (3) is flexible, and is composed of a polymer.

16. Method for producing a biometric sensor apparatus (30) having a sensor chip (1), a freely accessible fingerprint checking area (1) on the sensor chip (1), a mount substrate (3) and outer contact surfaces (4), which method has the following method steps:
a) provision of a sensor chip (1), with an earth contact surface (8) forming the lower face (21) of the sensor chip (1),
b) structuring of a metal coating (15, 22) on a mount substrate (3) in order to form earth connecting surfaces in the area of the sensor chip (1) and of a housing frame (7), and in order to form contact outer surfaces,
c) perforation of the edges (6) of the mount substrate (3),
d) fitting of the sensor chip (1) with its earth contact surface onto the structured metal coating (15, 22) in the area of the earth connecting surface for the sensor chip,
e) bonding of the contact surfaces (13) on the sensor chip (1) to the contact outer surfaces (4) on the mount substrate (3),
f) fitting of the housing frame (7) onto the structured metal coating (15, 22) in the area of the earth connecting surfaces for the housing frame,
g) selective sealing of the bonded connections by means of a plastic encapsulation compound.

17. Method according to Claim 16,
**characterized in that**
after the sealing process, the sensor chip surface (1) which is not used for fingerprint checking is covered by a housing cover (20).

18. Method according to Claim 16 or 17,
**characterized in that**
a sensor chip (1) is provided, having an earth contact surface (33) in the form of a frame on the upper face (26) of the sensor chip (1).

19. Method according to one of Claims 16 to 18,
**characterized in that**
the sensor surfaces (1) which are not used for fingerprint checking are covered by an electrically conductive housing additional cover (19) which is electrically connected to an earth contact surface (33) which is in the form of a frame, on the upper face (26) of the substrate chip (1).

20. Method according to one of Claims 16 to 19,
**characterized in that**
the intermediate spaces between the housing frame (7) and the sides of the sensor chips (1) are filled with a filler (27) composed of plastic.

21. Method according to one of Claims 16 to 20,
**characterized in that**
the metal coating (15) is structured by means of laser erosion.

22. Method according to one of Claims 16 to 20,
**characterized in that**
the metal coating (15) is structured using a photolithographic method.

23. Method according to one of Claims 16 to 20,
**characterized in that**
the metal coating (15) is structured by means of screen-printing methods or stencil-printing methods.

24. Method according to one of Claims 16 to 23,
**characterized in that**
the housing frame (7) is fitted by means of an adhesive bonding technique.

25. Method according to one of Claims 16 to 23,
**characterized in that**
the housing frame (7) is fitted by means of soldering methods.

## Revendications

1. Dispositif à capteur biométrique avec un capteur biométrique en puce (1), un boîtier pour le capteur biométrique en puce (1), avec une surface de contrôle d'empreinte digitale librement accessible (2) sur le capteur biométrique en puce (1), un substrat de support (3) et des surfaces extérieures de contact(4) sur le substrat de support (3), dans lequel le substrat de support (3) est une bande de support (5) avec des bords perforés (6) sur laquelle les surfaces extérieures de contact (4) peuvent être disposées partiellement hors d'un cadre de boîtier (7), et le capteur en puce (1) peut être positionné à l'intérieur du cadre de boîtier (7), une surface de contact de masse (8), formant la face inférieure du capteur en puce, du capteur en puce (1) reposant sur le substrat de support étant reliée avec le cadre de boîtier (7) pour former un cadre de masse (9).

2. Dispositif selon la revendication 1, **caractérisé en ce que** les surfaces extérieures de contact (4) sont disposées sur la face inférieure (10) du substrat de support (3) et sont reliées par des orifices de connexion (11) dans le substrat de support (3) et des fils de connexion (12) avec les surfaces de contact (13) sur le capteur en puce (1).

3. Dispositif selon la revendication 1 ou 2, **caractérisé en ce que** les surfaces extérieures de contact (4) sont disposées du côté de la puce du substrat de support (3).

4. Dispositif selon l'une quelconque des revendications précédentes, **caractérisé en ce que** les surfaces de contact (13) du capteur en puce (1) et les surfaces extérieures de contact (4) du substrat de support sont disposées sur un bord (14) du capteur en puce (1) ou du substrat de support (3) qui est orienté vers un des bords perforés (6) de la bande de support (5).

5. Dispositif selon l'une quelconque des revendications précédentes, **caractérisé en ce qu'**une surface de contact de masse (8) du capteur en puce (1) est reliée électriquement par un revêtement métallique structuré (15) sur la bande de support (5) en matériau isolant avec le cadre de boîtier (7).

6. Dispositif selon la revendication 5, **caractérisé en ce que** le revêtement métallique structuré (15) présente du côté intérieur du cadre de boîtier (7) vers l'extérieur du cadre de boîtier (7) des surfaces extérieures de contact conductrices (4) qui, à l'intérieur du cadre de boîtier (7), sont dotées de fils de connexion (12) et, à l'extérieur du cadre de boîtier (7), sont librement accessibles.

7. Dispositif selon la revendication 5 ou 6, **caractérisé en ce que** le cadre de boîtier (7) est fixé dans la zone des surfaces extérieures de contact (4) avec une colle isolante (16) sur le support de substrat (3) et, dans les autres zones du support de substrat (3), relié électriquement par une colle conductrice (17) et un revêtement métallique (15) avec la surface de contact de masse (8) du capteur en puce (1).

8. Dispositif selon l'une quelconque des revendications précédentes, **caractérisé en ce que** le cadre de boîtier (7) est constitué d'un cadre de masse (9) avec des ouvertures de montage (18).

9. Dispositif selon l'une quelconque des revendications précédentes, **caractérisé en ce que** le capteur en puce (1) est recouvert en dehors de la surface de contrôle d'empreinte digitale (2) par un cache supplémentaire (19).

10. Dispositif selon l'une quelconque des revendications précédentes, **caractérisé en ce que** le boîtier (30) présente un cache de masse (20) recouvrant les surfaces en dehors de la surface de contrôle d'empreinte digitale (2).

11. Dispositif selon l'une quelconque des revendications précédentes, **caractérisé en ce que** le boîtier (30) est constitué par une pièce emboutie qui présente le cadre de masse (9) et un cache de masse (20).

12. Dispositif selon l'une quelconque des revendications précédentes, **caractérisé en ce que** sur la bande de support sont montés des condensateurs de support.

13. Dispositif selon l'une quelconque des revendications précédentes, **caractérisé en ce que** le substrat de support (3) est une bande sans fin.

14. Dispositif selon l'une quelconque des revendications précédentes, **caractérisé en ce que** le substrat de support (3) est constitué de résine époxy.

15. Dispositif selon l'une quelconque des revendications 1 à 13, **caractérisé en ce que** le substrat de support (3) est flexible et est constitué d'un polymère.

16. Procédé de fabrication d'un dispositif à capteur biométrique (30) avec un capteur en puce (1), une surface de contrôle d'empreinte digitale librement accessible (2) sur le capteur en puce (1), un substrat de support (3) et des surfaces extérieures de contact (4), qui présente les étapes de procédé suivantes :
a) fabrication d'un capteur en puce (1), une surface de contact de masse (8) formant la face inférieure (21) du capteur en puce (1),
b) structuration d'un revêtement métallique (15, 22) sur un substrat de support (3) pour des surfaces de connexion à la masse dans la zone du capteur en puce (1) et d'un cadre de boîtier (7) ainsi que pour des surfaces extérieures de contact.
c) perforation des bords (6) du substrat de support (3),
d) montage du capteur en puce (1) avec sa surface de contact à la masse sur le revêtement métallique structuré (15, 22) dans la zone de la surface de connexion à la masse pour le capteur en puce,
e) liaison des surfaces de contact (13) sur le capteur en puce (1) avec les surfaces extérieures de contact (4) sur le substrat de support (3),
f) montage du cadre de boîtier (7) sur le revêtement métallique structuré (15, 22) dans la zone des surfaces de connexion à la masse pour le cadre de boîtier,
g) scellement sélectif des liaisons de connexion au moyen d'une masse de scellement en matière plastique.

17. Procédé selon la revendication 16, **caractérisé en ce qu'**après le scellement est effectué un recouvrement de la surface du capteur en puce (1) qui ne sert pas au contrôle d'empreinte digitale avec un cache de boîtier (20).

18. Procédé selon la revendication 16 ou 17 **caractérisé en ce que** le capteur en puce (1) est fabriqué avec une surface de contact de masse en forme de cadre (33) sur la face supérieure (26) du capteur en puce (1).

19. Procédé selon l'une quelconque des revendications 16 à 18 **caractérisé en ce que** les surfaces du capteur (1) qui ne servent pas au contrôle d'empreinte digitale sont recouvertes par un cache supplémentaire de boîtier électro-conducteur (19) qui est relié électriquement avec une surface de contact de masse en forme de cadre (33) sur la face supérieure (26) de la puce sur substrat (1).

20. Procédé selon l'une quelconque des revendications 16 à 19 **caractérisé en ce que** les espaces intermédiaires entre le cadre de boîtier (7) et les côtés du capteur en puce (1) sont remplis avec un produit de charge (27) en matière plastique.

21. Procédé selon l'une quelconque des revendications 16 à 20 **caractérisé en ce que** la structuration du revêtement métallique (15) se fait par érosion au laser.

22. Procédé selon l'une quelconque des revendications 16 à 20 **caractérisé en ce que** la structuration du revêtement métallique (15) se fait avec un procédé de photolithographie.

23. Procédé selon l'une quelconque des revendications 16 à 20 **caractérisé en ce que** la structuration du revêtement métallique (15) se fait au moyen d'un procédé de sérigraphie ou un procédé d'impression au pochoir.

24. Procédé selon l'une quelconque des revendications 16 à 23 **caractérisé en ce que** l'application du cadre de boîtier (7) se fait au moyen d'une technique de collage.

25. Procédé selon l'une quelconque des revendications 16 à 23 **caractérisé en ce que** l'application du cadre de boîtier (7) se fait au moyen d'un procédé de brasage.
